# EUROPÄISCHE PATENTSCHRIFT

(11) **EP 0 961 125 B1**
(45) Veröffentlichungstag und Bekanntmachung des Hinweises auf die Patenterteilung: **12.01.2005**
(21) Anmeldenummer: 99108660.4
(22) Anmeldetag: 14.05.1999
(51) Int. Cl.: G01R 29/18, G01R 31/02

(54) **Vorrichtung zur Identifizierung der Phasenzuordnung von Mittelspannungskabeln**
Device for identifying the phase relation of medium voltage cables
Dispositif d'identification de l'affectation de phases de câbles à moyenne tension

(30) Priorität: 28.05.1998 DE 29809604 U
(43) Veröffentlichungstag der Anmeldung: 01.12.1999
(73) Patentinhaber: Seba-Dynatronic Mess- und Ortungstechnik GmbH, 96148 Baunach (DE)
(72) Erfinder: Pfaff, Helmut, 77756 Hausach (DE); Fleischmann, Oliver, 96163 Gundelsheim (DE); Schlapp, Hubert, 96106 Ebern (DE)
(74) Vertreter: Riebling, Peter, Dr.-Ing.

(56) Entgegenhaltungen:
- WO-A-85/04726
- DE-U- 9 315 977
- US-A- 3 891 811

## Beschreibung

Gegenstand der Erfindung ist die Phasenbestimmung insbesondere in Mittelspannungsnetzen. Die Phasenbestimmung wird hierbei im geerdeten und kurzgeschlossenen Zustand der drei Phasen durchgeführt und dient dazu, einen Leiter aus einem Kabelbündel zwischen dem Meßende und dem Abschlußende aus mehreren vorhandenen Leitern heraus zu identifizieren.

Hierzu ist es bekannt, und nach der VBG 4 der Berufsgenossenschaft vorgeschrieben, daß am fernen Meßende eine Erdung vorgenommen wird. Das heißt, die drei Phasen müssen über eine ortsveränderliche oder über eine feste Erdungseinrichtung geerdet werden, um eine Spannungseinspeisung in diesem Bereich zu vermeiden.
Nun wird die Messung der Phasenbestimmung durch die am fernen Ende angeordnete Erdungsvorrichtung behindert oder gar verunmöglicht. Um dies nun zu vermeiden, wird nach dem DE-GM 93 15 977.3 vorgeschlagen, daß am geerdeten Ende zangenartige Signalvorrichtungen eingesetzt werden, wobei jede Zange eine Phase umschließt. Am Meßende, welches in beträchtlicher Entfernung vom Erdungsende sein kann, ist diese Phase geöffnet und kann in Richtung zur Erde gemessen werden.
Um nun die einzelnen Phasen voneinander zu unterscheiden, sieht die bekannte Vorrichtung vor, daß jede Meßzange eine Tonfrequenz einkoppelt, die von anderen, verwendeten Tonfrequenzen unterscheidbar ist. Auf diese Weise kann durch Identifizierung der Tonfrequenz in der Phase am Meßende entschieden werden, welche Phase nun gerade gemessen wird.

Zwar ist bei der GM 93 15 977.3 eine Bedienung durch eine einzige Person möglich. Nur wenn an einem Verteilerschrank gemessen werden soll (im Gegensatz zu einer Transformator-Station), kann man die Schranktür nicht schließen.

Durch die Zuleitung zwischen Sender und Zangen muß die Tür offen bleiben.
Dann aber schreiben die Sicherheitsregeln vor, daß eine fachkundige Person zur Aufsicht dort bleiben muß.

Ein weiteres Problem ist die Sicherheit, denn durch die Tatsache bedingt, daß die Tonfrequenzanordnung am Erdungsende angeordnet ist, besteht der Nachteil, daß dort der Verteilerschrank offen gelassen werden muß und daher auch für den Zugriff von Unbefugten zugänglich ist. Wenn sich die dortige Bedienungsperson entfernt, kann es passieren, daß die Erdungseinrichtung abgeklemmt wird und dann in unerwünschter Weise Strom auf die zu messende Phase gegeben wird, wodurch die Gefahr eines tödlichen Unfalls am Meßende zu vergegenwärtigen ist. Eine weitere Vorrichtung zur Identifikation von leitern ist in WO 85/04726 A offenbart.

Der Erfindung liegt deshalb die Aufgabe zugrunde, ein Verfahren und eine Vorrichtung der eingangs genannten Art so weiterzubilden, daß bei wesentlich einfacherer Messung die Betriebssicherheit verbessert wird.

Zur Lösung der gestellten Aufgabe ist die Erfindung durch die Merkmale des Anspruches 1 gekennzeichnet.

Wesentlich nach der Erfindung ist also, daß mit der erfindungsgemäßen Ausbildung der Zange eine Umkehrung des bekannten Prinzips stattfindet: Die Zange funktioniert selbst als Transponder und die Bereitstellung der Sendeenergie zur Anregung und Betrieb der Zange und auch der Empfang der Phaseninformation erfolgen nunmehr am Arbeitsende (Meßende).
Damit besteht der wesentliche Vorteil, daß man den Zangen nicht mehr eine feste Tonfrequenz zur Identifizierung zuordnet, sondern daß man erst vom Meßende aus die einzelnen Zangen anspricht, um diese zu einer entsprechenden Selbstidentifizierung zu veranlassen.

Am Meßende wird also zunächst eine Tonfrequenz eingespeist, die einen Energiespeicher in der Zange auflädt. Es handelt sich hierbei vorzugsweise um einen Kondensator.
Es wird eine feste Sendezeit vorgegeben, so daß entsprechend der ausgesandten Tonfrequenz der Energiespeicher (Kondensator) in einer bestimmten Meßzeit mit Energie aufgeladen ist. Nach Abschluß der Meßzeit ist der Kondensator auf eine bestimmte Spannung aufgeladen und die Zange beginnt ein digitales Telegramm in die zu identifizierende Leitung (Phase) hinein zu senden. Die Zange erhält nämlich nach dem Ende der Energieübertragung eine digitale Aufforderung vom Sender. Damit kann der Sender einzelne Zangen oder auch alle Zangen zur Identifizierung auffordern. Es ist aber in einer anderen Ausführungsform zusätzlich eine selbständige Antwort (ohne vorherige Aufforderung) vorgesehen.

Bei der Erfindung besteht also der Vorteil, daß mit dem erfindungsgemäßen Transpondersystem nur eine Ein-Mann-Bedienung vorgesehen werden muß, weil eben nur die Bedienungsperson am Meßende vorgesehen ist, während am Erdungsende die Zange selbständig eingesetzt wird und der gesamte Schrank abgeschlossen werden kann, weil keine gesonderten Meßeinrichtungen und externe Tonfrequenzeinrichtungen mehr verwendet werden müssen.

Beim Auslesen zweier Richtungen oder zweier Kabelstecker muß nur die Anzahl der Transponderzangen verdoppelt werden. Der Sender bleibt gleich. Bei dem GM 93 15 977.3 müssen 2 Sender mit je 3 Zangen verwendet werden, was den Aufwand deutlich erhöht.
Die vorliegende Erfindung ist vorzugsweise für die Identifizierung von Mittelspannungskabeln vorgesehen. Die Erfindung ist hierauf jedoch nicht beschränkt. Das System läßt sich demgemäß auch im Niederspannungsbereich einsetzen oder für andere geerdete Systeme. Aus Vereinfachungsgründen wird in der folgenden Beschreibung jedoch stets von einem Mittelspannungssystem ausgegangen.
Für eine eindeutige und sichere Identifizierung der Phasenzuordnung von Mittelspannungskabeln ist ein Meßsystem vorgesehen. Das System besteht aus zwei Einheiten, nämlich einer batterie-betriebenen Auslese- und Anzeigeeinheit, die dem Benutzer die Phasenzuordnung auf der Meßseite signalisiert und mehreren Satelliteneinheiten, die auf der fernen Seite (Erdungsseite) temporär installiert werden (Melder).
Der erste Arbeitsschritt bei der Phasenauslese ist aufgrund der Sicherheitsvorschriften die Erdung des fernen Endes. Dabei wird entweder die Erdung der Schaltanlage verwendet oder eine Erdungsgarnitur für alle drei Phasen angeschlossen. Bei diesem Arbeitsschritt werden auch die Meldereinheiten installiert, so daß kein zusätzlicher Arbeitsaufwand entsteht. Die Meldereinheiten werden als induktive Zangenkoppler realisiert.

Um die Handhabung zu erleichtern, besitzen diese Meldeeinheiten keine eigenen Batterien, sondern sie bekommen die Energie von der Ausleseeinheit übertragen und führen eine Zwischenspeicherung dieser Energie durch.
Die Meldereinheiten werden eindeutig (z.B. farblich und durch Beschriftung) gekennzeichnet, damit eine Verwechslung ausgeschlossen werden kann. Die zu messenden Kabel bilden also vom Meßort aus eine Schleife, da die Kabelmäntel an die Stationserde angeschlossen sind.

Das Ausleseverfahren arbeitet in einem zweistufigen Prozeß. Zuerst überträgt die Auswerteeinheit die Energie zu den Meldern. Dazu ist eine geeignete Frequenz auszuwählen, die leicht zu erzeugen ist, störsicher übertragen und gut ausgekoppelt werden kann.

Nach Ende des Energietransfers antwortet der Melder mit der Phasennummer und Kenndaten für die Zuverlässigkeit der Übertragung. Selbstverständlich können noch weitere Parameter übertragen werden. Für diese Rückübertragung ist eine geeignetes Übertragungsverfahren zu wählen. Besondere Bedeutung hat dabei die Störfestigkeit und Übertragungssicherheit. Die Meßorte sind im Normalfall Schaltanlagen oder Trafostationen, in denen elektrische und ,magnetische Störfelder auftreten und zusätzlich auch Schalttransienten entstehen können.
Es muß auch sichergestellt sein, daß nicht angesprochene Melder keine Fehlsignalisierung verursachen können.
Das Übertragungsprotokoll soll so gestaltet sein, daß maximal 3 Kabelstrecken mit je 3 Einzelkabeln unterschieden werden können.

Die Auswerteeinheit empfängt die Phaseninformation (z.B. L1a ,L2a oder L3a) des Melders und signalisiert sie dem Benutzer. Es wird hierbei bevorzugt, wenn ein Prozessor mit Textdisplay verwendet wird, um die Auslesung so einfach wie möglich zu gestalten.
Es muß auch darauf geachtet werden, daß sich im Meßkreis keine Kreisströme der Betriebsfrequenz und deren Harmonischen bilden können. Durch die Ströme von Parallelkabeln kann eine induktive Spannungseinkopplung in die Meßschleife erfolgen, die dann Störströme verursacht.

Es soll auch eine Information abgeleitet werden können, die dem Benutzer signalisiert, ob die Auslese zuverlässig ist. Dazu sollte zumindest die Aufladung der Energiespeicher (z.B. der Speicherkondensatoren) in den Meldern überprüft werden und mit zur Auswerteeinheit übertragen werden.
Die Streckenlängen sind typisch 100-1000 Meter. Es gibt allerdings auch Strecken bis über 10 km Länge.

Im folgenden wird die Erfindung anhand von lediglich einen Ausführungsweg darstellenden Zeichnungen näher erläutert. Hierbei gehen aus den Zeichnungen und ihrer Beschreibung erfindungswesentliche Merkmale und Vorteile der Erfindung hervor.

Es zeigen:
Fig. 1: Schematisiert einen Aufbau nach der Erfindung
Fig. 2: Eine detailliertere Darstellung des Meßaufbaus

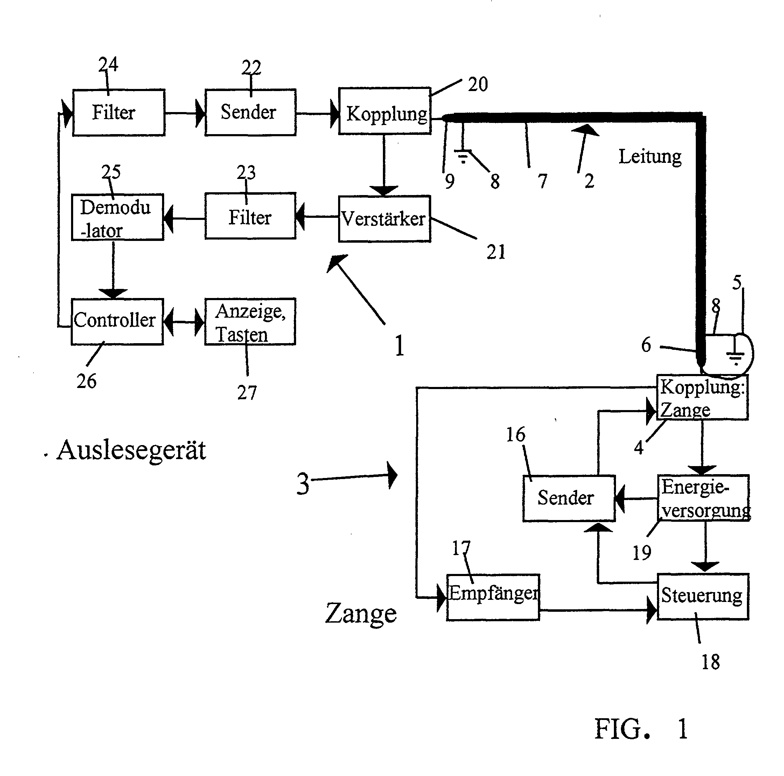

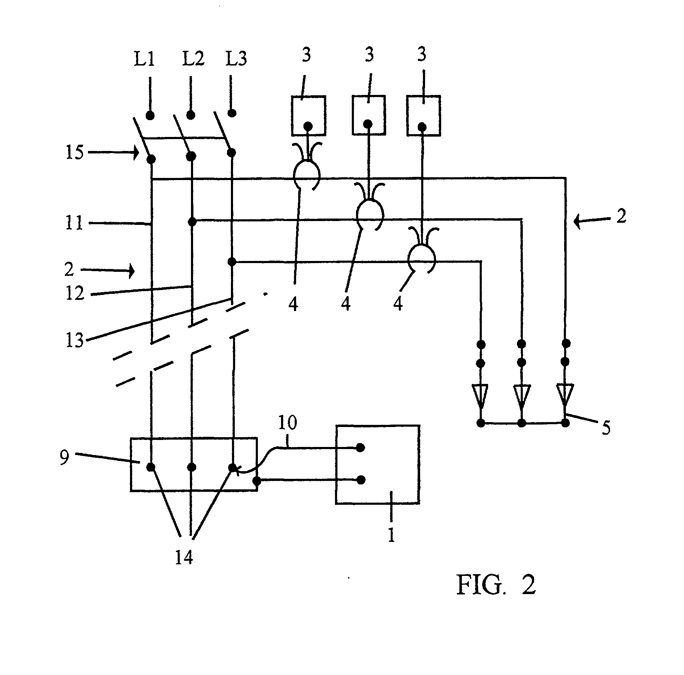

In Fig. 1 ist eine zu untersuchende Leitung 2 mit mehreren Leitungen 11-13 dargestellt. Am Meßende 9 ist das Auslesegerät 1 angeordnet, während am Erdungsende 6 eine Erdungsbrücke 5 (siehe Fig. 2) angeordnet ist, welche alle Leiter gegen Erde kurzschließt. Der Kabelmantel 7 der Leitung 2 liegt an der Erdung 8.
Erfindungsgemäß besteht die Identifizierungseinrichtung aus jeweils einer Kopplungszange 4, die mit einer Zangenschalteinrichtung 3 verbunden ist. Die Leitung 2 ist von der Stromversorgung über den Netzschalter 15 abgeschaltet. Um nun im Bereich der Anschlüsse 14 eine Phase aus den vorhandenen drei Phasen (L1, L2, L3) zu identifizieren, wird vom Auslesegerät 1 mit der Prüfleitung 10 einer der Anschlüsse 14 kontaktiert.
Das gesendete Signal ist vorzugsweise ein unmoduliertes Sinussignal. Um unerwünschte Kopplungen zu minimieren wird ein oberwellenarmes Signal gewählt.
Erst nach dem Energietransfer erfolgt die digitale Signalisierung (hier FSK).
Dieses Signal wird über die Leitung 13 zu der dieser Leitung zugeordneten Kopplungszange 4 gesendet. Dieses Signal wird von der Kopplungszange induktiv erfaßt und der Zangenschalteinrichtung 3 zugeführt. Die über die Leitung mit übertragene Tonfrequenz lädt die Energieversorgung 19 (z.B. Kondensator) auf, welche die anderen Schaltungsbestandteile (Empfänger 17, Steuerung 18 und Sender 16) der Zangenschalteinrichtung 3 versorgt. Der Empfänger nimmt daher das digitale Sendesignal der Ausleseeinheit 1 auf und steuert über die Steuerung 18 den Sender 16 an, der über die Kopplungszange 4 wiederum das digitale Identifizierungssignal in die Leitung 13 zurücksendet. Dieses Signal wird von dem Auslesegerät 1 erfaßt.

Das Auslesegerät 1 besteht im wesentlichen aus einem Empfangsteil und einem Sendeteil. Das Empfangsteil besteht aus einer Kopplung 20 und einem Verstärker 21, der das empfangene Signal verstärkt und über ein Filter 23 einem Demodulator 25 zuführt, der seinerseits eine Steuerung 26 ansteuert. Diese Steuerung stellt das empfangene Signal auf einer Anzeige- und Eingabeeinheit 27 optisch und/oder akustisch dar.

Für den Sendebetrieb steuert die Steuerung 26 den Filter 24 an, der seinerseits den Sender 22 ansteuert, der über die Kopplung 20 die zur Aufladung der Stromversorgung notwendige Wechselspannung (z. B. als Tonfrequenz) zusammen mit dem digitalen Signal auf die Leitung 13 aussendet.

Wichtig bei der Erfindung ist also, daß die Kopplungszangen 4 mit ihren Zangenschalteinrichtungen 3 lediglich als Transponder wirken. Es wird also lediglich ein Identifizierungssignal auf Anforderung vom Auslesegerät 1 erzeugt und in die Leitung 11-13 gesendet.
Von Vorteil ist, daß diese Transponder (=Melder) keine eigene Stromversorgung benötigen.

Auch ist die Erfindung nicht auf die Übertragung digitaler Identifizierungssignale beschränkt. Die Information kann auch durch analoge modulierte Signale (Amplituden-, oder Frequenz- oder Phasenmodulation) übertragen werden.

### Zeichnungslegende

- 1.: Auslesegerät
- 2.: Leiterbündel
- 3.: Zangenschalteinrichtung
- 4.: Kopplungszange
- 5.: Erdungsbrücke
- 6.: Erdungsende
- 7.: Kabelmantel
- 8.: Erdung
- 9.: Meßende
- 10.: Prüfleitung
- 11.: Leiter L1
- 12.: Leiter L2
- 13.: Leiter L3
- 14.: Anschluß
- 15.: Netzschalter
- 16.: Sender
- 17.: Empfänger
- 18.: Steuerung
- 19.: Energiespeicher
- 20.: Kopplung
- 21.: Verstärker
- 22.: Sender
- 23.: Filter
- 24.: Filter
- 25.: Demodulator
- 26.: Steuerung
- 27.: Anzeige- und Eingabeeinrichtung

## Patentansprüche

1. Vorrichtung zur Phasenidentifizierung der Phasenzuordnung, insbesondere von Mittelspannungskabeln, von einem Meßende (9) aus, mit einem von der Stromversorgung abgeschalteten Leiterbündel (2) mit mehreren zu identifizierenden Leitern (11,12,13), die am Erdungsende (6) mit einer Erdungsbrücke (5) geerdet sind, wobei zur Identifizierung am Erdungsende (6) der zu identifizierende Leiter (11,12,13) mit einer induktiven Kopplungszange (4) umschlossen ist, die ein Identifizierungssignal erzeugt und auf den zu identifizierenden Leiter (11,12,13) einkoppelt, welches Identifizierungssignal am Meßende (9) mit einem Auslesegerät (1) ausgelesen und identifiziert wird,
wobei die jeweilige Kopplungszange (4) mit Zangenschalteinrichtung (3) als Transponder geschaltet ist und die Bereitstellung der Sendeenergie zur Anregung und Betrieb der Kopplungszange (4) am Meßende (9) durch das als Sende- und Empfangsteil ausgebildete Auslesegerät (1) erfolgt, welches in den zu identifizierenden Leiter (11,12,13) eine Tonfrequenz einspeist, welche einen Energiespeicher (19) in der Zangenschalteinrichtung (3) auflädt und wobei die Aussendung des Identifizierungssignals von dem am Meßende (9) angeordneten Auslesegerät (1) anforderbar ist.

2. Vorrichtung nach Anspruch 1, **dadurch gekennzeichnet, daß** das Identifizierungssignal eine digitale Signalabfolge ist, in welcher ein Identifikationscode der jeweiligen Kopplungszange (4) enthalten ist.

3. Vorrichtung nach einem der Ansprüche 1-2, **dadurch gekennzeichnet, daß** die am Meßende (9) angeordnete Ausleseeinheit (1) batteriebetrieben ist.

4. Vorrichtung nach einem der Ansprüche 1-3, **dadurch gekennzeichnet, daß** die Übertragung des Identifizierungssignals über die Leiter (11-13) eine zusätzliche Information über die Qualität der Übertragung beinhaltet.

5. Vorrichtung nach einem der Ansprüche 1-4, **dadurch gekennzeichnet, daß** die Zangenschalteinrichtung (3) im Griffgehäuse der Kopplungszange (4) eingebaut ist.

6. Vorrichtung nach einem der Ansprüche 1-5, **dadurch gekennzeichnet, daß** die Aussendung des Identifizierungssignals zu dem am Meßende (9) angeordneten Auslesegerät (1) automatisch ohne vorherige Aufforderung erfolgt.

7. Vorrichtung nach einem der Ansprüche 1-6, **dadurch gekennzeichnet, daß** der Energiespeicher (19) als Kondensator ausgebildet ist.

## Claims

1. Device for the phase identification of the phase allocation, in particular of medium voltage cables, from one measuring end (9), comprising a conductor bundle (2), which is switched off from the power supply, with a plurality of conductors (11, 12, 13) which are to be identified and are earthed at the earthing end (6) with an earthing jumper (5), wherein the conductor (11, 12, 13) to be identified is surrounded by inductive coupling tongs (4) for identification at the earthing end (6), the coupling tongs generating an identification signal and coupling it to the conductor (11, 12, 13) to be identified, which identification signal is read out and identified at the measuring end (9) by a readout apparatus (1), wherein the respective coupling tongs (4) are switched as a transponder with a tong switching mechanism (3), and the transmission energy to excite and operate the coupling tongs (4) at the measuring end (9) is provided by the readout apparatus (1) which is formed as a transmitting and receiving part and feeds an audio frequency into the conductor (11, 12, 13) to be identified, the audio frequency charging an energy accumulator (19) in the tong switching mechanism (3) and wherein transmission of the identification signal can be requested by the readout apparatus (1) arranged at the measuring end (9).

2. Device according to claim 1, **characterised in that** the identification signal is a digital signal sequence, in which an identification code of the respective coupling tongs (4) is contained.

3. Device according to either of claims 1 or 2, **characterised in that** the readout unit (1) arranged at the measuring end (9) is battery-operated.

4. Device according any one of claims 1 to 3, **characterised in that** the transmission of the identification signal via the conductors (11 to 13) contains additional information about the transmission quality.

5. Device according to any one of claims 1 to 4, **characterised in that** the tong switching mechanism (3) is installed in the handle housing of the coupling tongs (4).

6. Device according to any one of claims 1 to 5, **characterised in that** the identification signal is transmitted to the readout apparatus (1) arranged at the measuring end (9) automatically without a prior request.

7. Device according to any one of claims 1 to 6, **characterised in that** the energy accumulator (19) is formed as a capacitor.

## Revendications

1. Dispositif pour identifier l'affectation de phases, en particulier de câbles moyenne tension, à partir d'une extrémité de mesure (9), comportant un faisceau de conducteurs (2) déconnecté de l'alimentation en courant et formé de plusieurs conducteurs à identifier (11, 12, 13) qui sont mis à la terre avec un pont de mise à la terre (5), au niveau de l'extrémité de terre (6), étant précisé que pour l'identification, on entoure le conducteur à identifier (11, 12, 13), sur l'extrémité de terre (6), avec une pince de couplage inductive (4) qui génère un signal d'identification et le couple sur ledit conducteur (11, 12, 13), lequel signal d'identification est lu et identifié sur l'extrémité de mesure (9) à l'aide d'un lecteur (1), que la pince de couplage respective (4) est montée avec un dispositif d'actionnement de pince (3) sous la forme d'un transpondeur et l'énergie d'émission destinée à exciter et à faire fonctionner ladite pince de couplage (4) est fournie au niveau de l'extrémité de mesure (9) par le lecteur (1), conçu comme un élément émetteur et récepteur, qui introduit dans le conducteur à identifier (11, 12, 13) une fréquence acoustique qui charge un accumulateur d'énergie (19) dans le dispositif d'actionnement de pince (3), et que l'émission du signal d'identification peut être demandée par le lecteur (1) disposé sur l'extrémité de mesure (9).

2. Dispositif selon la revendication 1, **caractérisé en ce que** le signal d'identification est une suite de signaux numériques dans laquelle est contenu un code d'identification de la pince de couplage respective (4).

3. Dispositif selon la revendication 1 ou 2, **caractérisé en ce que** l'unité de lecture (1) disposée sur l'extrémité de mesure (9) fonctionne sur batterie.

4. Dispositif selon l'une des revendications 1 à 3, **caractérisé en ce que** la transmission du signal d'identification par l'intermédiaire des conducteurs (11-13) contient une information supplémentaire sur la qualité de la transmission.

5. Dispositif selon l'une des revendications 1 à 4, **caractérisé en ce que** le dispositif d'actionnement de pince (3) est intégré dans le boîtier de poignée de la pince de couplage (4).

6. Dispositif selon l'une des revendications 1 à 5, **caractérisé en ce que** l'émission du signal d'identification vers le lecteur (1) disposé sur l'extrémité de mesure (9) se fait automatiquement, sans demande préalable.

7. Dispositif selon l'une des revendications 1 à 6, **caractérisé en ce que** l'accumulateur d'énergie (19) est conçu comme un condensateur.
